# EUROPEAN PATENT APPLICATION

(11) **EP 4 297 086 A1**
(43) Date of publication of application: **27.12.2023**
(21) Application number: 22774142.8
(22) Date of filing: 18.03.2022
(51) Int. Cl.: H01L 23/60, H01L 27/02

(54) **INTEGRATED CIRCUIT, CHIP AND ELECTRONIC DEVICE**

(30) Priority: 23.03.2021 CN 202110310515
(71) Applicant: Huawei Technologies Co., Ltd., Shenzhen, Guangdong 518129 (CN)
(72) Inventor: CHANG, Hsianghui, Shenzhen, Guangdong 518129 (CN); ZHANG, Yi, Shenzhen, Guangdong 518129 (CN); ZHANG, Yawen, Shenzhen, Guangdong 518129 (CN); WU, Lei, Shenzhen, Guangdong 518129 (CN); WU, Jianfeng, Shenzhen, Guangdong 518129 (CN); TENG, Zhaoyu, Shenzhen, Guangdong 518129 (CN); LI, Tingzhao, Shenzhen, Guangdong 518129 (CN); ZHANG, Binbin, Shenzhen, Guangdong 518129 (CN); WANG, Qiang, Shenzhen, Guangdong 518129 (CN)
(74) Representative: Maiwald GmbH
(86) International application number: PCT/CN2022/081679
(87) International publication number: WO 2022/199481

(57) **Abstract**

Embodiments of this application provide an integrated circuit, a chip, and an electronic device, and relate to the field of microelectronic circuit technologies, to reduce an integrated circuit malfunction caused by electrostatic discharge. The integrated circuit includes a substrate and a transistor disposed on the substrate. A gate of the transistor is coupled to a first end of a switch component, and a second end of the switch component is coupled to a ground end. The switch component is configured to be in a turn-on state or a turn-off state under control of a control signal received by a control end. The switch component in the turn-on state transmits an electrostatic voltage of the gate of the transistor to the ground end. Alternatively, the switch component in the turn-off state disconnects the gate of the transistor from the ground end.

## Description

This application claims priority to Chinese Patent Application No. 202110310515.1, filed with the China National Intellectual Property Administration on March 23, 2021 and entitled "INTEGRATED CIRCUIT, CHIP, AND ELECTRONIC DEVICE", which is incorporated herein by reference in its entirety.

### TECHNICAL FIELD

This application relates to the field of microelectronic circuit technologies, and in particular, to an integrated circuit, a chip, and an electronic device.

### BACKGROUND

Currently, electrostatic discharge (electrostatic discharge, ESD) often occurs in an assembly process of an integrated circuit (for example, a process of mounting the integrated circuit to a package substrate). The electrostatic discharge is generally harmful and cannot be eliminated, and consequently may damage the integrated circuit. For example, a signal pad (a pad pad, a pin pin, and the like) of the integrated circuit generates static electricity in the assembly process, and an electrostatic discharge current may be discharged from a transistor coupled to the signal pad in the integrated circuit. This damages the transistor coupled to the signal pad in the integrated circuit, and consequently causes an integrated circuit malfunction. Especially, for a high electron mobility transistor (high electron mobility transistor, HEMT) with a channel layer epitaxially formed through heteroepitaxy on a substrate by using a group III nitride material that is different from a material of the substrate, a gate leakage current of such the transistor is large during operation. When an ESD event occurs on a gate, a physical structure in the gate subject to an ESD pulse is almost only a gate dielectric layer and a barrier layer. When a current passing through is greater than a fixed value, the gate dielectric layer suffers breakdown, causing a component malfunction.

### SUMMARY

Embodiments of this application provide an integrated circuit, a chip, and an electronic device, to reduce an integrated circuit malfunction caused by electrostatic discharge.

To achieve the foregoing objective, this application uses the following technical solutions.

According to a first aspect, an integrated circuit is provided. The integrated circuit may be in a form of a bare core, a bare chip, or a die (die). The integrated circuit includes: a substrate and a transistor disposed on the substrate. A gate of the transistor is coupled to a first end of a switch component, and a second end of the switch component is coupled to a ground end. The switch component is configured to be in a turn-on state or a turn-off state under control of a control signal received by a control end. The switch component in the turn-on state transmits an electrostatic voltage of the gate of the transistor to the ground end. Alternatively, the switch component in the turn-off state disconnects the gate of the transistor from the ground end. In this way, in a process of mounting the integrated circuit to a package substrate, an electrostatic voltage V_{ESD} of a gate G of the transistor is transmitted to a ground end GND by configuring the switch component on the integrated circuit to be in the turn-on state. This can effectively avoid a malfunction of the integrated circuit due to breakdown of the transistor by electrostatic discharge. In addition, after the integrated circuit is mounted to the package substrate, the switch component on the integrated circuit is configured to be in the turn-off state, to ensure that the gate G of the transistor and the ground end GND are disconnected, thereby ensuring a normal function of the transistor during operation. In addition, in an on-chip screening stage before the integrated circuit is mounted to the package substrate, a control signal is applied to a control pad Pm to enable the switch component to be in the turn-off state to disconnect the gate G from the ground end GND of the transistor. A test signal may be applied to a gate pad connected to the gate G of the transistor, and the on-chip screening of the transistor is implemented by detecting an output signal of a drain D. In the process of mounting the integrated circuit to the package substrate, the control signal is applied to the control pad to enable the switch component to be in the turn-on state (where, alternatively, another state of the switch component is a constant turn-on state, and it may be understood that when a state of the switch component such as an HEMT is a constant turn-on state, the control signal may be applied to a gate of the HEMT to change the state of the HEMT to a turn-off state, and when the switch component is in the constant turn-on state, no control signal is applied to the gate of the switch component, or the control signal is 0). In this way, the gate G of the transistor and the ground end GND are short-circuited via the switch component, and the electrostatic voltage V_{ESD} of the gate G of the transistor is transmitted to the ground end GND through the switch component. After the integrated circuit is mounted to the package substrate, to ensure normal operation of the transistor, the gate G of the transistor and the ground end GND need to be disconnected. Therefore, the switch component is disconnected via the control signal, so that the gate G of the transistor and the ground end GND are disconnected.

In a possible implementation, the control end of the switch component is coupled to the control pad, and the control pad is configured to receive the control signal.

In a possible implementation, the gate of the transistor is further coupled to the gate pad, and the gate of the transistor is electrically connected to the gate pad through a via. Because the gate of the transistor generally covers inside a protective layer, to connect the gate of the transistor to another component such as the package substrate, a pad (a gate pad) generally needs to be prepared outside the protective layer to connect the gate of the transistor, so that when the integrated circuit is connected to the another component such as the package substrate in a mounting manner, the pad (the gate pad) outside the protective layer is connected to a pad on the package substrate. In this way, a PCB provides a signal to the integrated circuit or transmits a signal output by the integrated circuit to the PCB.

In a possible implementation, the switch component includes a depletion mode HEMT. A first source of the depletion mode HEMT is coupled to the ground end, a second source of the depletion mode HEMT is coupled to the gate of the transistor, and a gate of the depletion mode HEMT is coupled to the control pad. The control pad is electrically connected to the gate of the depletion mode HEMT through a via. The depletion mode HEMT is in a turn-on state, or the gate of the depletion mode HEMT receives a first control voltage transmitted by the control pad, and the depletion mode HEMT is in a turn-off state under control of the first control voltage. A source S of the depletion mode HEMT may be understood as the first source, and a drain D of the depletion mode HEMT may be understood as the second source. In an embodiment, the source S of the depletion mode HEMT is coupled to a first end of an electrostatic discharge wire, and the drain D of the depletion mode HEMT is coupled to the gate of the transistor. In another embodiment, the drain D of the depletion mode HEMT may alternatively be coupled to a first end of an electrostatic discharge wire, and the source S of the depletion mode HEMT may be coupled to the gate of the transistor. In addition, in the process of mounting the integrated circuit to the package substrate, because the foregoing pads (the gate pad and the control pad) are packaged, the control signal cannot be applied to the control pad via a probe in this process. In addition, if the control signal may be applied to the control pad via the probe, ESD may also be directly discharged via the probe, and there is no electrostatic discharge problem. Therefore, the switch component may be the depletion mode HEMT. Because the depletion mode HEMT is in a constant turn-on state when no signal is applied to the gate (or the control signal is 0), and for the depletion mode HEMT, there is sufficient two-dimensional electron gas concentration when no voltage is applied to the gate. Therefore, the source S and the drain D of the depletion mode HEMT are in the constant turn-on state. To turn off the depletion mode HEMT, a negative voltage needs to be added to the gate G of the depletion mode HEMT. When the negative voltage provided by the gate G of the depletion mode HEMT is less than a threshold voltage, the depletion mode HEMT is turned off, and the negative voltage of the gate G of the depletion mode HEMT generates an electric field opposite to a built-in electric field, to reduce energy bending of a heterojunction interface of a barrier layer/channel layer, reduce a depth of a triangular potential well, and reduce the two-dimensional electron gas concentration. Therefore, in the process of mounting the integrated circuit to the package substrate, the electrostatic voltage V_{ESD} of the gate G of the transistor may be transmitted to the ground end GND by using the depletion mode HEMT in the constant turn-on state.

In a possible implementation, the transistor and/or the switch component include/includes a transistor of a fin-gate structure.

In a possible implementation, a channel layer of the transistor includes group III nitrides.

In a possible implementation, a channel layer of the transistor includes a material different from a material of the substrate, and the channel layer is located on the substrate.

In a possible implementation, a channel layer and a barrier layer of the depletion mode HEMT include group III nitrides.

In a possible implementation, a thickness of a gate dielectric layer of the depletion mode HEMT is greater than a thickness of a gate dielectric layer of the transistor. In the process of mounting the integrated circuit to the package substrate, a control pad Pm also accumulates electrostatic charges. Therefore, the gate of the depletion mode HEMT also has an ESD problem. To reduce a risk of breakdown of the gate dielectric layer and the barrier layer of the depletion mode HEMT, a sufficient thickness of the gate dielectric layer of the depletion mode HEMT is set. For example, to withstand 100 V ESD, the thickness of the gate dielectric layer is about 200 nm. When the gate dielectric layer of the depletion mode HEMT and the gate dielectric layer of the transistor use a same material, the thickness of the gate dielectric layer of the depletion mode HEMT is greater than the thickness of the gate dielectric layer of the transistor.

In a possible implementation, a thickness of the barrier layer of the depletion mode HEMT is less than a thickness of the barrier layer of the transistor. After the gate dielectric layer is thickened, because a gate capacitance is reduced, a capability of depleting electrons becomes weak. Therefore, a lower negative voltage is needed to completely deplete the electrons under the channel layer. This is obviously unacceptable. Another way to reduce a voltage required for depleting the electrons is to reduce a total quantity of electrons, to reduce the voltage required for depleting the electrons. The most effective way to reduce the quantity of electrons is to reduce the thickness of the barrier layer. Therefore, when the barrier layer of the depletion mode HEMT and the barrier layer of the transistor use a same material, the thickness of the barrier layer of the depletion mode HEMT is less than the thickness of the barrier layer of the transistor.

In a possible implementation, a thickness of the barrier layer of the depletion mode HEMT is 0.1 nm to 100 nm.

In a possible implementation, a thickness of the gate dielectric layer of the depletion mode HEMT is 0.1 nm to 200 nm.

In a possible implementation, a threshold voltage of the depletion mode HEMT is -60 Vto -0.1 V

In a possible implementation, the integrated circuit is a monolithic microwave integrated circuit MMIC.

According to a second aspect, a chip is provided, including the foregoing integrated circuit and package substrate, where the integrated circuit is coupled to the package substrate.

According to a third aspect, an electronic device is provided, including a printed circuit board and the foregoing chip, where the chip is coupled to the printed circuit board.

According to a fourth aspect, an electrostatic protection method is provided and is applied to the integrated circuit provided in the first aspect. The method includes: in the process of mounting the integrated circuit to a package substrate, controlling a switch component to be in a turn-on state, and conducting an electrostatic voltage of a gate of a transistor to a ground end.

In a possible implementation, before the integrated circuit is mounted to the package substrate, the method further includes: controlling the switch component to be in a turn-off state, and outputting a test signal to the gate of the transistor.

In a possible implementation, after the integrated circuit is mounted to the package substrate, the method includes: controlling the switch component to be in the turn-off state.

For technical effects brought by any one of possible implementations in the second aspect, the third aspect, and the fourth aspect, refer to technical effects brought by the foregoing different implementations of the first aspect. Details are not described herein again.

### BRIEF DESCRIPTION OF DRAWINGS

FIG. 1A is a schematic structural diagram of an electronic device according to an embodiment of this application;
FIG. 1B is a schematic structural diagram of an electronic device according to another embodiment of this application;
FIG. 1C is a schematic structural diagram of an electronic device according to still another embodiment of this application;
FIG. 2 is a schematic structural diagram of a base station according to an embodiment of this application;
FIG. 3 is a schematic structural diagram of a chip according to an embodiment of this application;
FIG. 4 is a schematic structural diagram of an integrated circuit according to an embodiment of this application;
FIG. 5 is a schematic structural diagram of an integrated circuit according to another embodiment of this application;
FIG. 6 is a schematic structural diagram of an integrated circuit according to still another embodiment of this application;
FIG. 7 is a schematic diagram of a principle of an ESD problem of an HEMT according to an embodiment of this application;
FIG. 8 is a schematic structural diagram of an integrated circuit according to yet another embodiment of this application;
FIG. 9 is a schematic structural diagram of an integrated circuit according to another embodiment of this application;
FIG. 10 is a schematic structural diagram of an integrated circuit according to still another embodiment of this application;
FIG. 11 is a schematic structural diagram of an integrated circuit according to yet another embodiment of this application;
FIG. 12 is a schematic diagram of a process flow of an integrated circuit according to an embodiment of this application;
FIG. 13 is a schematic structural diagram of an integrated circuit according to another embodiment of this application;
FIG. 14 is a schematic structural diagram of an integrated circuit according to still another embodiment of this application;
FIG. 15 is a schematic structural diagram of an integrated circuit according to yet another embodiment of this application;
FIG. 16 is a schematic structural diagram of an integrated circuit according to another embodiment of this application;
FIG. 17 is a schematic structural diagram of an integrated circuit according to still another embodiment of this application;
FIG. 18 is a schematic structural diagram of an integrated circuit according to yet another embodiment of this application;
FIG. 19 is a schematic structural diagram of an HEMT according to an embodiment of this application;
FIG. 20 is a schematic structural diagram of an HEMT according to another embodiment of this application;
FIG. 21 is a schematic structural diagram of an HEMT according to another embodiment of this application;
FIG. 22 is a schematic structural diagram of an HEMT according to another embodiment of this application;
FIG. 23 is a schematic curve diagram of a relationship between a thickness of a barrier layer and a thickness of a gate dielectric and each of a gate capacitance and a gate voltage of an HEMT according to an embodiment of this application; and
FIG. 24 is a schematic structural diagram of an integrated circuit according to another embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Unless defined otherwise, all technical and scientific terms used herein have the same meaning as commonly understood by a person of ordinary skill in the art to which this disclosure belongs. In this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. At least one of the following items (pieces) or a similar expression thereof refers to any combination of these items, including any combination of singular items (pieces) or plural items (pieces). For example, at least one of a, b, or c may represent: a, b, c, a and b, a and c, b and c, or a, b, and c, where a, b, and c may be singular or plural. In addition, in embodiments of this application, the terms such as "first" and "second" are not intended to limit a quantity or an execution sequence.

In addition, in this application, position terms such as "top" and "bottom" are defined relative to positions of components in the accompanying drawings. It should be understood that these position terms are relative concepts used for relative description and clarification, and may correspondingly change based on changes in the positions of the components in the accompanying drawings.

It should be noted that, in this application, terms such as "an example" or "for example" are used to indicate an example, an instance, or an illustration. Any embodiment or design scheme described as an "example" or "for example" in this application should not be explained as being more preferred or having more advantages than another embodiment or design scheme. Exactly, use of the word "example", "for example", or the like is intended to present a related concept in a specific manner.

An integrated circuit and a chip provided in embodiments of this application may be applied to an electronic device. The electronic device may be different types of terminals such as a mobile phone, a tablet, a personal computer (personal computer, PC), a personal digital assistant (personal digital assistant, PDA), a smartwatch, a netbook, a wearable electronic device, an augmented reality (augmented reality, AR) device, a virtual reality (virtual reality, VR) device, an in-vehicle device, an intelligent vehicle, a smart speaker, a robot, and smart glasses. The electronic device may alternatively be a network device such as a base station. Alternatively, the electronic device may be an apparatus such as a chip in the foregoing electronic device. The electronic device may further include a printed circuit board, and the foregoing chip is disposed on the printed circuit board. The integrated circuit disposed on a package substrate is packaged in the chip, and the integrated circuit may be connected to the package substrate in a mounting manner. A specific form of the electronic device is not specifically limited in embodiments of this application.

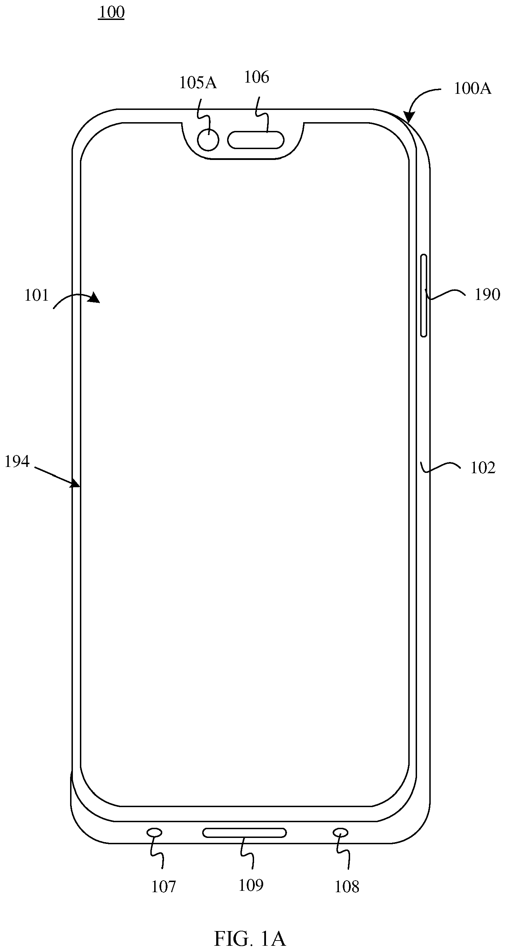

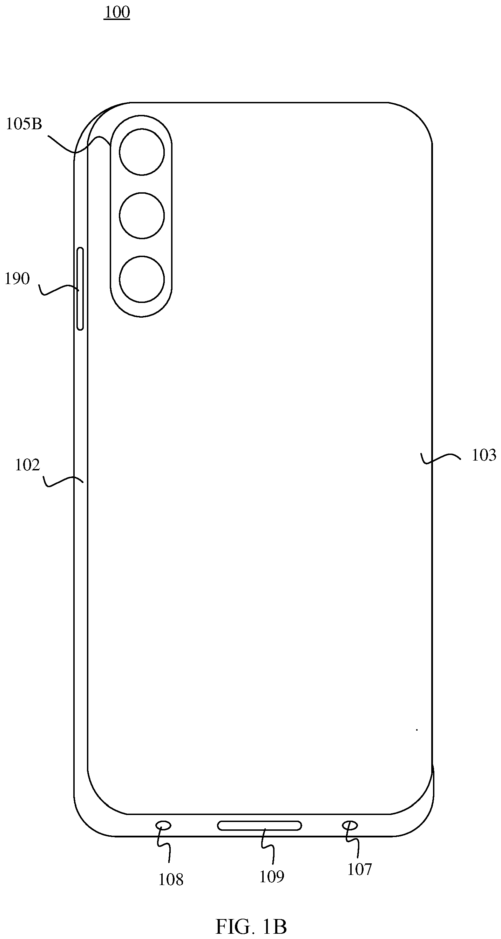

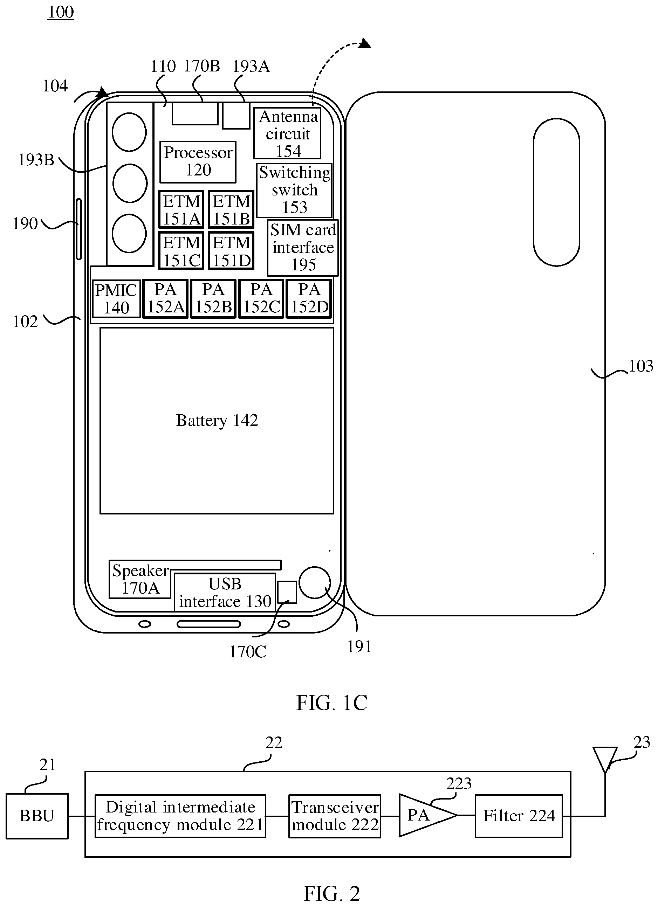

A mobile phone is used as an example. FIG. 1 Ato FIG. 1C shows a schematic structural diagram of an electronic device 100. FIG. 1A shows a top view of the electronic device 100 according to the described embodiment. FIG. 1B shows a bottom view of the electronic device 100 according to the described embodiment. FIG. 1C shows a top view of the electronic device 100 with a rear cover opened. The top view shows a specific configuration of each internal part according to the described embodiment. A dashed arrow in FIG. 1C indicates a direction in which the rear cover is opened. It may be understood that a structure shown in this embodiment does not constitute a specific limitation on the electronic device 100. In some other embodiments of this application, the electronic device 100 may include more or fewer components than the components shown in the figure, or some components may be combined, or some components may be split, or different component arrangements may be used.

As shown in FIG. 1A and FIG. 1B, the electronic device 100 may include an enclosure 100A. The enclosure 100A may include a front cover 101, a rear cover 103, and a bezel 102. The front cover 101 and the rear cover 103 are disposed opposite to each other. The bezel 102 surrounds the front cover 101 and the rear cover 103, and connects the front cover 101 and the rear cover 103. The front cover 101 may be a glass cover, and a display 194 is disposed below the front cover 101. The electronic device 100 may be provided with an input/output component peripherally around the enclosure 100A. For example, a hole 105A of a front-facing camera and a hole 106 of a receiver may be disposed on the top of the front cover 101. A key 190 may be disposed on an edge of the bezel 102, and a hole 107 of a microphone, a hole 108 of a speaker, and a hole 109 of a USB interface may be disposed on a bottom edge of the bezel 102. A hole 105B of a rear-facing camera may be disposed on the top of the rear cover 103.

The enclosure 100A may have a cavity 104 inside, and an internal component is packaged in the cavity. As shown in FIG. 1C, an internal component may be accommodated in a cavity 104. The internal component may include components such as a printed circuit board (printed circuit board, PCB) 110, a speaker 170A configured to convert an audio electrical signal into a sound signal, a receiver 170B configured to convert an audio electrical signal into a sound signal, a microphone 170C configured to convert a sound signal into an electrical signal, a USB interface 130, a front-facing camera 193A, a rear-facing camera 193B, and a motor 191 configured to generate a vibration prompt. The printed circuit board 110 may be provided with components such as a processor 120, a power management integrated circuit (power management integrated circuit, PMIC) 140, at least one power amplifier (where in an embodiment, a power amplifier (power amplifier, PA) 152A, a power amplifier PA 152B, a power amplifier PA 152C and a power amplifier PA 152D are included, and different power amplifiers PAs support different frequency bands and are configured to amplify transmit signals of the different frequency bands, for example, the power amplifier PA 152A and the power amplifier PA 152B may be configured to amplify a transmit signal within a first bandwidth range, a power amplifier PA 152C and a power amplifier PA 152D may be configured to amplify a transmit signal within a second bandwidth range), at least one envelope tracking modulator (envelope tracking modulator) ETM configured to supply power to the power amplifier (where in an embodiment, an envelope tracking modulator ETM 151A and an envelope tracking modulator ETM 151B are included, and different envelope tracking modulators ETMs support different bandwidths, for example, the envelope tracking modulator ETM 151A supplies power to the power amplifier PA 152A and the power amplifier PA 152B, and the envelope tracking modulator ETM 151B supplies power to the power amplifier PA 152C and the power amplifier PA 152D), a switching switch 153, and an antenna circuit 154. In addition, the printed circuit board 110 may further include components such as a filter, a low noise amplifier, an audio codec, an internal memory, a sensor, an inductor, and a capacitor. For ease of clearly illustrating this embodiment, the filter, the low noise amplifier, the audio codec, the internal memory, the sensor, the inductor, and the capacitor are not shown in FIG. 1C. The components on the printed circuit board 110 are closely arranged, so that all the components are placed in limited space. A manner of arranging the components on the printed circuit board 110 is not limited. In some embodiments, the components on the printed circuit board 110 may be disposed on a side of the printed circuit board 110 (for example, a side facing the rear cover 102). In some embodiments, the components on the printed circuit board 110 may be disposed on two sides of the printed circuit board 110 (for example, on the side facing the rear cover 102, and on a side facing the front cover 101).

The processor 120 may include one or more processing units. For example, the processor 120 may include an application processor (application processor, AP), a modem processor, a graphics processing unit (graphics processing unit, GPU), an image signal processor (image signal processor, ISP), a neural-network processing unit (neural-network processing unit, NPU), a controller, a video codec, a digital signal processor (digital signal processor, DSP), a baseband, and/or a radio frequency circuit. The controller may generate an operation control signal based on instruction operation code and a time sequence signal, to complete control of instruction reading and instruction execution.

A memory may be disposed in the processor 120, and is configured to store instructions and data. In some embodiments, the memory in the processor 120 includes a cache. The memory may store instructions or data that are just used or cyclically used by the processor 120. If the processor 120 needs to use the instructions or the data again, the instructions or the data may be directly invoked from the memory. This avoids repeated access, reduces waiting time of the processor 120, and improves system efficiency.

The processor 120 may perform frequency modulation on a signal according to a mobile communication technology or a wireless communication technology. The mobile communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), an emerging wireless communication technology (which may also be referred to as a fifth generation mobile communications technology, English: 5th generation mobile networks or 5th generation wireless systems, 5th-Generation, or 5th-Generation New Radio, and is referred to as 5G, a 5G technology, or 5G NR for short), and the like. The wireless communication technology may include a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, and the like.

The processor 120 may further include at least one baseband and at least one radio frequency circuit. The baseband is configured to synthesize a to-be-transmitted baseband signal, or/and decode a received baseband signal. Specifically, during transmission, the baseband encodes a voice signal or another data signal into a baseband signal (baseband code) for transmission; and during receiving, the baseband decodes a received baseband signal (baseband code) into a voice signal or another data signal. The baseband may include components such as an encoder, a decoder, and a baseband processor. The encoder is configured to synthesize the to-be-transmitted baseband signal, and the decoder is configured to decode the received baseband signal. The baseband processor may be a microprocessor (MCU). The baseband processor may be configured to control the encoder and the decoder. For example, the baseband processor may be configured to complete scheduling of encoding and decoding, communication between the encoder and the decoder, and peripheral driving (the baseband processor may send an enable signal to a component outside the baseband, to enable the component outside the baseband), and the like. The radio frequency circuit is configured to process a baseband signal to form a transmit (transmit, TX) signal, and transfer the transmit signal to a power amplifier PA for amplification; or/and the radio frequency circuit is configured to process a receive (receive, RX) signal to form a baseband signal, and send the formed baseband signal to a baseband for decoding. In some embodiments, each baseband corresponds to one radio frequency circuit, to perform frequency modulation on the signal based on one or more communication technologies. For example, a first baseband and a first radio frequency circuit perform frequency modulation on the signal based on the 5G technology, a second baseband and a second radio frequency circuit perform frequency modulation on the signal based on a 4G technology, a third baseband and a third radio frequency circuit perform frequency modulation on the signal based on a Wi-Fi technology, and a fourth baseband and a fourth radio frequency circuit perform frequency modulation on the signal based on a Bluetooth technology, and the like. Alternatively, the first baseband and the first radio frequency circuit may perform frequency modulation on the signal based on both the 4G technology and the 5G technology, and the second baseband and the second radio frequency circuit perform frequency modulation on the signal based on the Wi-Fi technology, and the like. In some embodiments, one baseband may alternatively correspond to a plurality of radio frequency circuits, to improve integration.

In some embodiments, the baseband and radio frequency circuit and another component of the processor 120 may be integrated into an integrated circuit. In some embodiments, the baseband circuit and the radio frequency circuit each may be an independent component independent of the processor 120. In some embodiments, one baseband and one radio frequency circuit may be integrated into a component independent of the processor 120.

In the processor 120, different processing units may be independent components, or may be integrated into one or more integrated circuits.

The antenna circuit 154 is configured to transmit and receive an electromagnetic wave signal (a radio frequency signal). The antenna circuit 154 may include a plurality of antennas or a plurality of groups of antennas (a group of antennas include more than two antennas), and each antenna or the plurality of groups of antennas may be configured to cover one or more communication bands. The plurality of antennas each may be one or more of a multi-frequency antenna, an array antenna, or an on-chip (on-chip) antenna.

The processor 120 is coupled to the antenna circuit 154, to implement various functions associated with transmitting and receiving the radio frequency signal. For example, when the electronic device 100 transmits a signal, the baseband synthesizes to-be-transmitted data (a digital signal) into a to-be-transmitted baseband signal, the radio frequency circuit convert the baseband signal into a transmit signal (a radio frequency signal) the power amplifier amplifies the transmit signal, and the amplified output signal that is output by the power amplifier is transferred to the switching switch 153 and then is transmitted by the antenna circuit 154. A path on which the transmit signal is sent from the processor 120 to the switching switch 153 is a transmit link (or referred to as a transmit path). When the electronic device 100 needs to receive a signal, the antenna circuit 154 sends a received signal (a radio frequency signal) to the switching switch 153, the switching switch 153 sends a radio frequency signal to the radio frequency circuit, the radio frequency circuit processes the radio frequency signal into a baseband signal, and the radio frequency circuit converts the processed baseband signal into data and then sends the data to a corresponding application processor. A path on which the radio frequency signal is sent from the switching switch 153 to the processor 120 is a receive link (or referred to as a receive path).

The switching switch 153 may be configured to selectively electrically connect the antenna circuit 154 to the transmit link or the receive link. In some embodiments, the switching switch 153 may include a plurality of switches. The switching switch 153 may be further configured to provide additional functions, including signal filtering and/or duplexing (duplexing).

A SIM card interface 195 is configured to connect to a SIM card. The SIM card may be inserted into the SIM card interface 195 or removed from the SIM card interface 195, to implement contact with or separation from the electronic device 100. The electronic device 100 may support one or N SIM card interfaces, where N is a positive integer greater than 1. The SIM card interface 195 may support a Nano-SIM card, a micro-SIM card, a SIM card, and the like. A plurality of cards may be inserted into a same SIM card interface 195 at the same time. The plurality of cards may be of a same type or different types. Each SIM card may support one or more communication standards, and each communication standard has a specified frequency band and specifies different maximum bandwidths. The SIM card interface 195 may be compatible with different types of SIM cards. The SIM card interface 195 is also compatible with an external storage card. The electronic device 100 interacts with a network through the SIM card, to implement functions such as calling and data communication. In some embodiments, the electronic device 100 uses an eSIM, that is, an embedded SIM card. The eSIM card may be embedded into the electronic device 100, and cannot be separated from the electronic device 100.

The PMIC 140 is configured to manage power in the electronic device 100. For example, the PMIC 140 may include a charging management circuit and a power supply management circuit. The charging management circuit is configured to receive a charging input from a charger. For example, in some embodiments of wired charging, the charging management circuit may receive a charging input of a wired charger through a USB interface 130. The power supply management circuit is configured to receive input of a battery 142 and/or the charging management circuit, and supply power to components such as the processor 120, the display 194, the front-facing camera 193A, the rear-facing camera 193B, and the motor 191. In some other embodiments, the charging management circuit and the power supply management circuit may alternatively be disposed in the processor 120. In some other embodiments, the charging management circuit and the power supply management circuit may alternatively be disposed in different components.

In another example, a 5G base station is used as an example of the electronic device provided in embodiments of this embodiment. The 5G base station may be divided into different architectures such as a baseband unit (baseband unit, BBU)-active antenna unit (active antenna unit, AAU), a central unit-distribute unit (central unit-distribute unit, CU-DU)-AAU, a BBU-remote radio unit (remote radio unit, RRU)-antenna (antenna), a CU-DU-RRU-antenna, and a 5G node base station (5G node base station, gNB). A base station of the BBU-RRU architecture is used as an example. Refer to FIG. 2. The base station includes a BBU 21, an RRU 22, and an antenna 23, where the BBU 21 and the RRU 22 are connected by using an optical fiber, and an interface between the BBU 21 and the RRU 22 is based on an open CPRI (common public radio interface common public radio interface) and an OBSAI (open base station architecture initiative open base station architecture initiative). The BBU 21 processes a generated baseband signal through the RRU 22, and then sends the processed baseband signal to the antenna 23 for transmission. The RRU 22 includes a digital intermediate frequency module 221, a transceiver module 222, a power amplifier 223 (power amplifier, PA), and a filter 224. The digital intermediate frequency module 221 is configured to perform modulation and demodulation, digital up/down-conversion, D/A conversion (digital to analog conversion, digital to analog conversion), and the like on the baseband signal transmitted through the optical fiber, to form an intermediate frequency signal. The transceiver module 222 completes converting an intermediate frequency signal to a radio frequency signal. The power amplifier 223 is configured to perform power amplification on a low-power radio frequency signal. The filter 224 is configured to filter the radio frequency signal, and then transmit the radio frequency signal via the antenna 23.

All technologies in the following embodiments may be implemented in the foregoing electronic device. In the following embodiments, a component or a signal that has a same name as a component or a signal in the foregoing electronic device may be configured as a same component or a same signal in the foregoing electronic device. An integrated circuit, a chip, and an electronic device provided in embodiments of this application are described below by using examples.

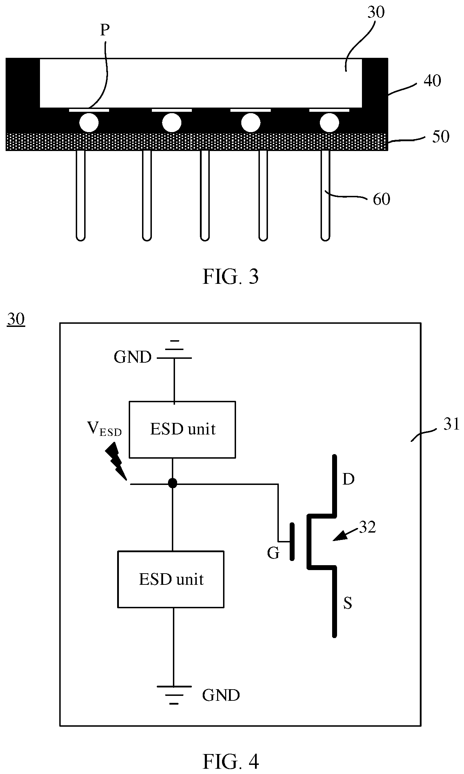

With reference to the foregoing descriptions, some components (for example, one or more of a processor, a power management integrated circuit, a PA, an ETM, a filter, a low noise amplifier, an audio codec, and an internal memory) in the electronic device may be disposed on the printed circuit board 110 in a form of a chip and coupled to the printed circuit board 110, for example, may be connected to the printed circuit board 110 in a form of pin (terminal pin) soldering or pad (pad pad) mounting. Some other components (such as a sensor, an inductor, and a capacitor) are connected to the printed circuit board 110 in a form of independent components through pin plugging (for example, board to board (board to board, BTB)) or soldering. With reference to FIG. 3, a chip is provided. The chip includes an integrated circuit 30 and a package substrate 50. The integrated circuit 30 is in a form of a bare core, a bare chip, or a die (die). The integrated circuit 30 is coupled to the package substrate 50. It should be noted that a functional circuit inside the integrated circuit 30 is coupled to a pad (a pin or a solder pad) on the package substrate 50 via a pad (a pin or a solder pad). For example, a pin P of the integrated circuit 30 is soldered to the pad (the pin or the solder pad) on the package substrate 50 via a solder ball. A metal wire (not shown) is disposed on the package substrate 50, and the metal wire connects the pin P of the integrated circuit 30 to a pin 60 of an external chip. In this way, when the chip is connected to the printed circuit board 110 via the pin 60 of the chip, a connection between the integrated circuit 30 and the printed circuit board 110 is implemented. In addition, a packaging material 40, for example, an insulation material such as resin or ceramic, is further filled around the integrated circuit 30.

Specifically, the integrated circuit 30 provided in this embodiment of this application may include a transistor applied to the PA of the electronic device provided in FIG. 1A to FIG. 1C or FIG. 2. Certainly, a specific application scenario is not limited to the mobile phone shown in FIG. 1A to FIG. 1C and the base station shown in FIG. 2. It may be understood that any electronic device that needs to process a signal by using a transistor belongs to an application scenario of embodiments of this application. The integrated circuit may be formed by connecting one or more transistors prepared on a substrate. For example, when being used to implement a radio frequency function in an electronic device, the integrated circuit may be a monolithic microwave integrated circuit (monolithic microwave integrated circuit, MMIC) or a radio frequency integrated circuit (radio frequency integrated circuit, RFIC). It may be understood that the MMIC may be integrated with the foregoing filter, low noise amplifier, and PA. In some examples, the MMIC may further be integrated with a frequency mixer, a frequency multiplier, a phased array unit, and the like.

As shown in FIG. 4, the integrated circuit 30 mainly includes a substrate 31 and a transistor 32 disposed on the substrate 31. In a process of mounting the integrated circuit 30 to the package substrate, to avoid a malfunction of the integrated circuit 30 due to breakdown of the transistor 32 by electrostatic discharge, generally, with reference to FIG. 4, a gate of the transistor 32 is generally connected to one or more electrostatic (ESD) protection units, and an electrostatic voltage V_{ESD} accumulated at the gate of the transistor 32 is transmitted to a ground end GND by using the one or more ESD protection units.

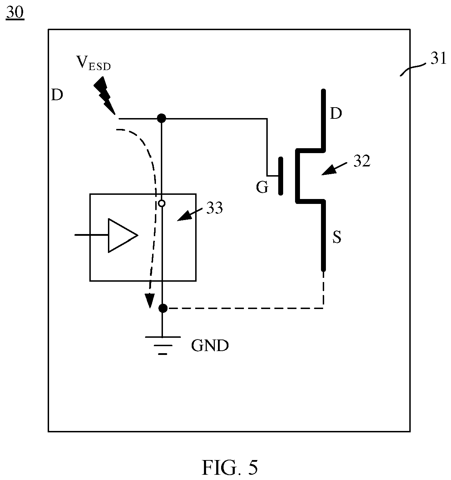

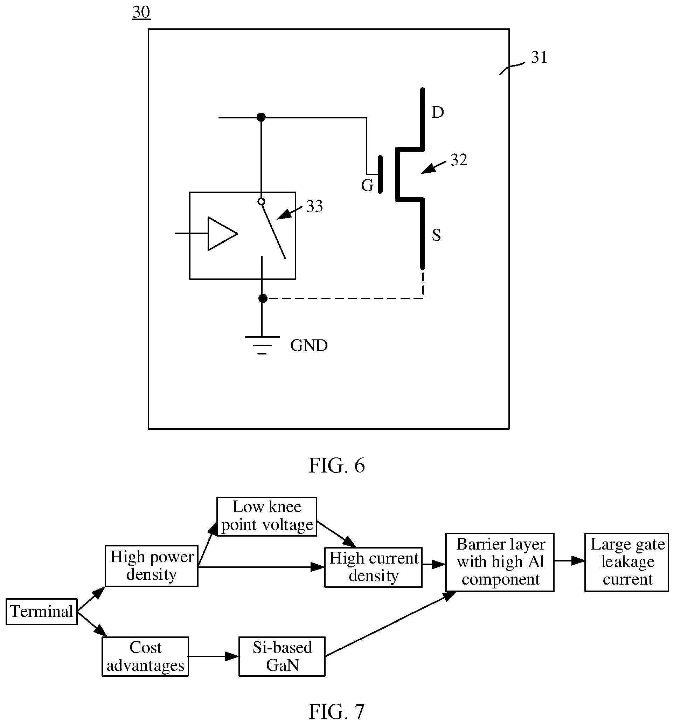

In an embodiment of this application, specifically, with reference to FIG. 5 and FIG. 6, the integrated circuit 30 mainly includes a substrate 31 and a transistor 32 disposed on the substrate 31. In some embodiments of this application, a gate (gate, G) of the transistor 32 is coupled to a first end of a switch component 33, and a second end of the switch component 33 is coupled to a ground end GND. The switch component 33 is configured to be in a turn-on state or a turn-off state under control of a control signal received by a control end. As shown in FIG. 5, the switch component 33 in the turn-on state transmits an electrostatic voltage V_{ESD} of the gate G of the transistor 32 to the ground end GND. Alternatively, as shown in FIG. 6, the switch component 33 in the turn-off state disconnects the gate G of the transistor 32 from the ground end GND. It should be noted that a source S of the transistor 32 is directly or indirectly connected to the ground end GND. For example, in some examples, the source S of the transistor 32 is connected to the ground end GND via some intermediate components (such as a resistor, an inductor, and a diode). Certainly, to reduce a parasitic parameter (such as a capacitance, a capacitance, or an inductance) between the transistor 32 and the ground end, the source S of the transistor 32 is generally directly connected to the ground end GND. In FIG. 5 and FIG. 6, the source S of the transistor 32 may be understood as a first source, and a drain D of the transistor 32 may be understood as a second source. In an embodiment, the source S of the transistor 32 is coupled to a ground end, and the drain D of the transistor 32 is coupled to a working power supply. In another embodiment, the drain D of the transistor 32 may be coupled to a ground end, and the source S of the transistor 32 is coupled to a working power supply.

In this way, in the process of mounting the integrated circuit 30 to the package substrate, the switch component 33 on the integrated circuit 30 is configured to be in the turn-on state, and the electrostatic voltage V_{ESD} of the gate G of the transistor 32 is transmitted to the ground end GND. This can effectively avoid a malfunction of the integrated circuit due to breakdown of the transistor 32 by electrostatic discharge. In addition, after the integrated circuit 30 is mounted to the package substrate, the switch component 33 on the integrated circuit 30 is configured to be in the turn-off state, to ensure that the gate G of the transistor 32 and the ground end GND are disconnected, thereby ensuring a normal function of the transistor 32 during operation.

Especially, a transistor with a channel layer formed through heteroepitaxialization based on a substrate has a severe ESD problem. The channel layer of such the transistor includes a material different from a material of the substrate, and the channel layer is located on the substrate, for example, epitaxially formed on the substrate. A high electron mobility transistor (high electron mobility transistor, HEMT) that uses group III nitrides is used as an example. The HEMT using the group III nitrides is widely used on a power amplifier of a base station. However, compared with the base station, a battery supply voltage of a terminal determines that the HEMT of the group III nitrides can operates only at a low voltage. This imposes a very high requirement on a current density of the HEMT. With reference to FIG. 7, a high current density is used to compensate for a lower power density caused by a lower operating voltage. In addition, the high current density is used to reduce a knee point voltage to increase an effective voltage swing. This requires that a barrier layer with, for example, a high aluminum (Al) component, is introduced into the HEMT of the group III nitrides, for example, an aluminum content is higher than 20%. In addition, from the perspective of cost control, it is a feasible solution to use silicon Si as a channel layer that is with group III nitrides and that is epitaxially formed on a substrate, rather than use silicon carbide SiC as the channel layer that is with the group III nitrides and that is epitaxially formed on the substrate. However, due to large lattice mismatch and thermal mismatch between Si and the group III nitrides (for example, gallium nitride GaN), growth of a high Al component material is difficult. As a result, the grown material is of poor quality and has many defects. After a Schottky contact is formed between a metal and these materials through a semiconductor process, these defects serve as leakage channels. As a result, a gate leakage current of an HEMT obtained based on the foregoing materials is large, and a component characteristic deteriorates. To reduce the gate leakage current, an insulation layer (a gate dielectric layer) needs to be introduced onto the barrier layer to form a metal-insulator-semiconductor (metal-insulator-semiconductor, MIS)-HEMT structure, to obtain a component with a low gate leakage current. In a process of mounting an integrated circuit (for example, in a form of a power amplifier chip, a bare chip, a die (die), or the like) of a group III nitride-based HEMT to a package substrate of a radio frequency module, an ESD problem inevitably exists. When an ESD event occurs on a gate, a physical structure subject to an ESD pulse is almost only a gate dielectric layer and a barrier layer. An MIS structure is an insulation medium. When a current passing through is greater than a fixed value, the insulation medium suffers breakdown, causing an HEMT malfunction. Although each pad (for example, the pin P in FIG. 3) of the group III nitrides-based integrated circuit is finally connected to the pin 60 outside the chip, in the chip, the pad (for example, the pin P shown in FIG. 3) of the group III nitrides-based integrated circuit is not exposed. However, in a back end of line process of an integrated circuit, for example, an integrated circuit packaging process, due to a problem in a production line management and control capability, an ESD event may occur in the integrated circuit, causing an integrated circuit malfunction. In this case, the integrated circuit using the group III nitrides and applied in a terminal cannot be mass produced due to the ESD problem.

However, according to the solutions provided in this embodiment of this application, in a process of mounting an integrated circuit to a package substrate, an electrostatic voltage V_{ESD} of a gate of a transistor is transmitted to a ground end GND via a switch component on the integrated circuit. This effectively avoids a problem of a malfunction of the integrated circuit due to breakdown of the transistor by electrostatic discharge.

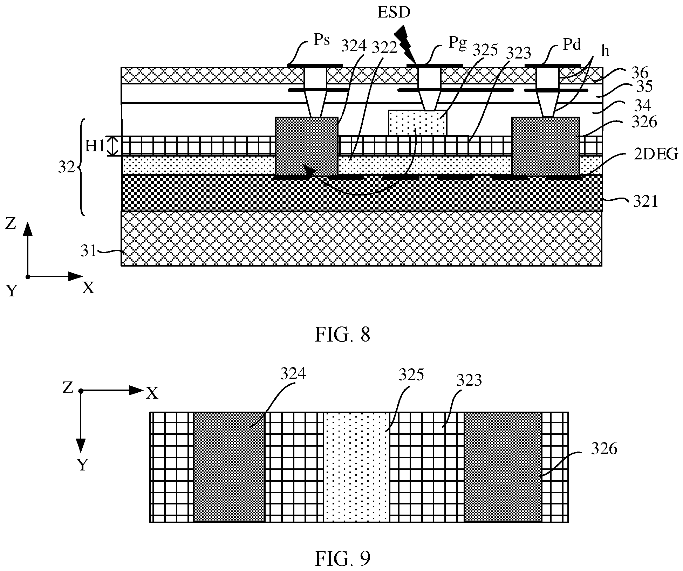

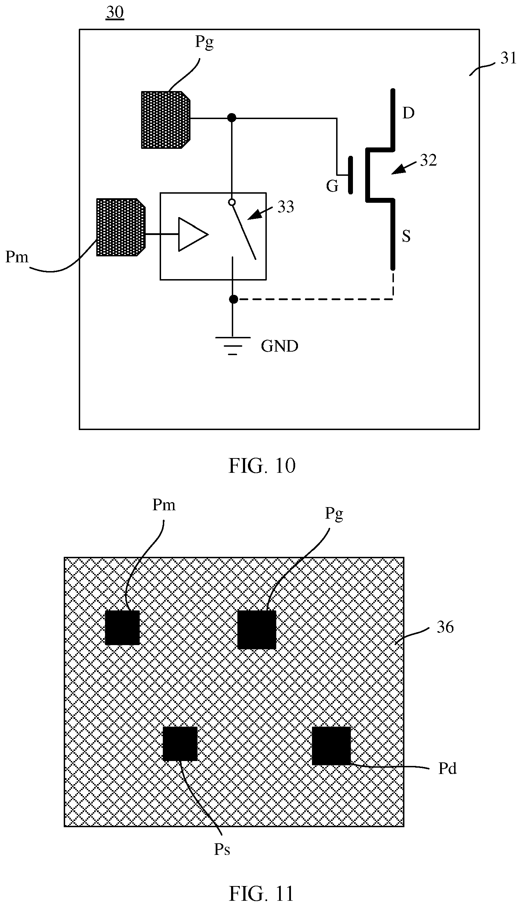

An integrated circuit including an HEMT is used as an example. The integrated circuit includes a laminated structure formed by a plurality of materials arranged in a laminated manner. As shown in FIG. 8 and FIG. 9, FIG. 8 shows a schematic diagram of a cross section of a transistor on an XZ plane in a three-dimensional coordinate space XYZ, and FIG. 9 shows a schematic structural diagram of a top view of the transistor in a Z direction. A transistor 32 mainly includes a channel layer 321, a barrier layer 322, a gate dielectric layer 323, and a pad on the gate dielectric layer 323 that are disposed on a substrate 31, where the pad may be a gate 325, a source 324, and a drain 326, and the source 324 and the drain 326 are in contact with the channel layer 321. In some examples, the pad is further covered with a first dielectric layer 34. When the HEMT is a group III nitride-based HEMT, the channel layer 321 and the barrier layer 322 in the transistor 32 generally include group III nitrides, where the group III nitrides are compounds formed by two or more elements. Several elements of the group III nitrides include an element N, and include one or more of group III elements such as aluminum Al, gallium Ga, and indium In in the element periodic table. Typical examples of the group III nitrides are, for example, gallium nitride GaN and/or aluminum gallium nitride AlGaN. The pad is generally made of metal, for example, copper Cu. The source 324 and the drain 326 each form a conductive ohmic contact with the barrier layer 324, and the gate 325 forms a Schottky contact with the barrier layer 322. A dotted line in the channel layer 321 represents two-dimensional electron gas (two-dimensional electron gas, 2DEG) generated in a heterostructure formed by the channel layer 321 and the barrier layer 322 in the HEMT. Electron mobility of the two-dimensional electron gas in a horizontal direction (for example, the dotted line in the channel layer 321 in FIG. 8) is very high, and is a basis for operation of the HEMT. In some examples, another functional layer structure may be further disposed between the channel layer 321 and the barrier layer 322, or between the channel layer 321 and the substrate 31. For example, an insertion layer may be disposed between the channel layer 321 and the barrier layer 322. A function of the insertion layer is to improve a density, a localization degree, and the electron mobility of the two-dimensional electron gas, to improve performance of the component, for example, obtain excellent switching performance. Therefore, the insertion layer is an optional structure. When no insertion layer is disposed in the HEMT, the performance of the component is reduced. In addition, a buffer layer may be disposed between the channel layer 321 and the substrate 31. The buffer layer is also an optional structure, and is mainly used as a transition function when a crystal structure of a material of the channel layer 321 greatly differs from a crystal structure of a material of the substrate 31. For example, when the crystal structure of the material of the channel layer 321 greatly differs from the crystal structure of the material of the substrate, a buffer layer that has a small difference from the crystal structure of the substrate may be first epitaxially formed on the substrate 31, and then the channel layer 321 is epitaxially formed on the buffer layer. Generally, a first dielectric layer 34 covering the transistor 32, and a metal wiring layer 35 and a protective layer 36 that are disposed on the first dielectric layer 34 are further disposed on the integrated circuit. A pad of the transistor 32 is electrically connected to metal wiring in the metal wiring layer 35 through a via h, and the metal wiring in the metal wiring layer 35 is electrically connected to a pad (a gate pad Pg, a source pad Ps, and a drain pad Pd) on an outer side of the protective layer 36 through the via h. Therefore, when the integrated circuit is connected to another component such as a package substrate in a manner of mounting, the pad on the outer side of the protective layer 36 is connected to a pad on the package substrate, so that a PCB provides a signal to the integrated circuit or transmits a signal output by the integrated circuit to the PCB. The protective layer 36 and the first dielectric layer 34 may be made of an insulation material such as silicon oxide or resin. The metal wiring layer 35 may be one or more layers of metal wiring used for interconnection that are formed in an insulation material layer (for example, silicon oxide) through one or more composition processes. Metal wiring at different layers may be electrically connected through a via (via), and the metal wiring is used to implement interconnection. The protective layer 36 is generally a material layer on an outmost layer of a die, and the protective layer is specifically configured to protect cabling of a component or metal wiring on the die. The via (via) in this embodiment of this application may also be referred to as a plated hole. Generally, to electrically connect conductive structures on two sides of a dielectric layer, a common hole, that is, the via, is drilled at an intersection of the conductive structures that need to be electrically connected on the two sides of the dielectric layer. In a process, a layer of a conductive material, for example, a metal, is made on a cylindrical surface of a wall of the via, to electrically connect conductive structures that need to be connected. In this embodiment of this application, the metal wiring in the metal wiring layer 35 may be electrically connected to the gate pad Pg, the source pad Ps, and the drain pad Pd through the via, and the metal wiring in the metal wiring layer 35 may be electrically connected to a gate G, a source S, and a drain D of the transistor 32 through the via. Specifically, as shown in FIG. 10 and FIG. 11, to lead out the gate 325, the source 324, and the drain 326 to be connected to another external component, the gate pad Pg, the source pad Ps, and the drain pad Pd that are disposed at layers different from layers at which the gate 325, the source 324, and the drain 326 are disposed are further included. The gate pad Pg, the source pad Ps, and the drain pad Pd are disposed on the outer side of the protective layer 36, the gate 325 of the transistor 30 is coupled to the gate pad Pg, the source 324 of the transistor 30 is coupled to the source pad Ps, and the drain 326 of the transistor 30 is coupled to the drain pad Pd. A control end of a switch component 33 is coupled to a control pad Pm, and the control pad Pm is configured to receive a control signal. The control pad Pm may be prepared on the outer side of the protective layer 36 with the gate pad Pg, the source pad Ps, and the drain pad Pd in FIG. 8. In addition, the control pad Pm may be coupled to a control end of a switch component M via the metal wiring in the metal wiring layer 35. FIG. 8 shows an example in which three pads (the gate pad Pg, the source pad Ps, and the drain pad Pd) are disposed on the outer side of the protective layer for the transistor for description. Certainly, when one of the gate G, the source S, and the drain D of the transistor is directly connected to another component in the integrated circuit, and does not need to be connected to an external circuit by using a pin of a chip, only any one or two of the gate pad Pg, the source pad Ps, and the drain pad Pd may alternatively be selectively disposed.

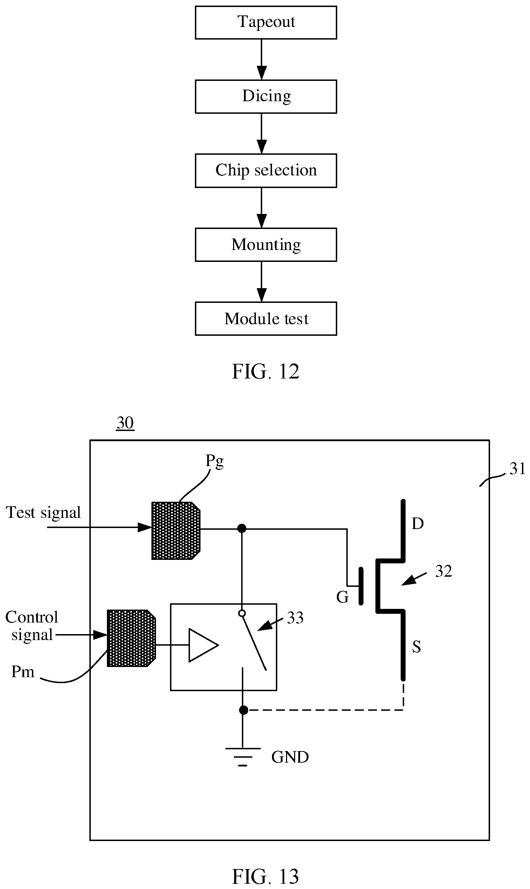

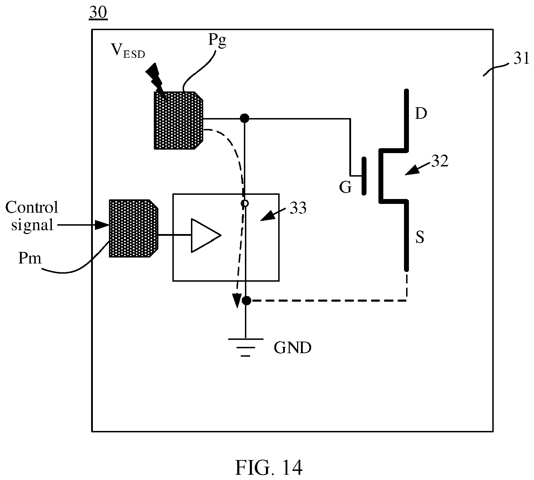

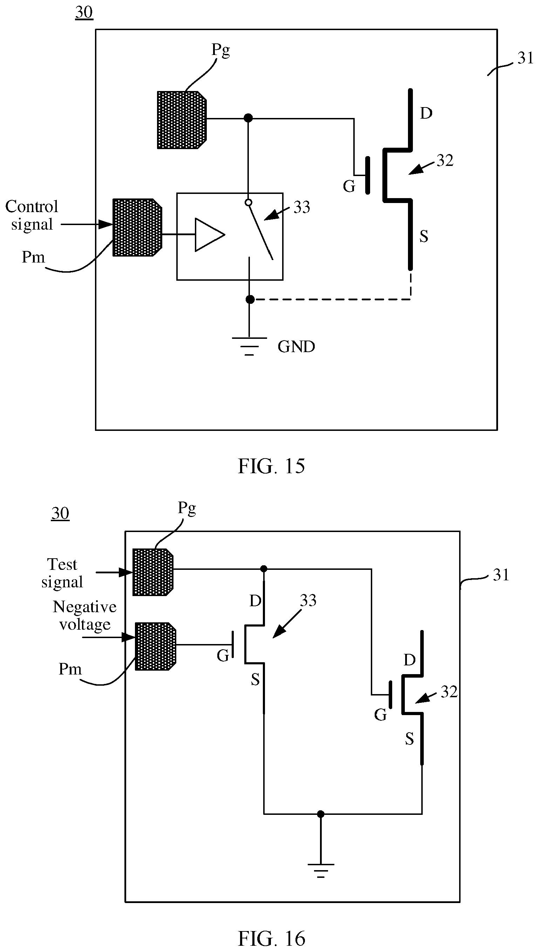

Currently, with reference to FIG. 12, after a chip is taped out and diced, costs of three parts including on-chip screening (chip selection), mounting and packaging, and module test screening are basically 1:1:1. A group III nitride-based integrated circuit is used an example. Currently, a yield of a mature process is only 80%, while a yield of a new process is only 70%. In this case, if the chip screening is not performed on an integrated circuit obtained through tapeout and dicing, but a defected bare chip is screened out through a module test after the chip is mounted and packaged, the costs are greatly increased. If the yield of the bare chip obtained through tapeout is 70%, a total cost difference between a process with on-chip screening and a process without on-chip screening reaches 20% ((1 + 0.7 + 0.7) / (1 + 1 + 1)). Therefore, from the perspective of cost control, on-chip screening needs to be performed on the bare chip. In this way, in an on-chip screening stage before the integrated circuit is mounted to the package substrate, refer to FIG. 13. A control signal is applied to a control pad Pm to enable a switch component 33 to be in a turn-off state to disconnect a gate G of the transistor 32 from a ground end GND. A test signal may be applied to a gate pad Pg connected to the gate G of the transistor 32, and the on-chip screening of the transistor 32 is implemented by detecting an output signal of a drain D. In the process of mounting the integrated circuit to the package substrate, refer to FIG. 14. The control signal is applied to the control pad Pm to enable the switch component 33 to be in a turn-on state (where, alternatively, another state of the switch component 33 is a constant turn-on state, and it may be understood that when a state of a switch component such as an HEMT is the constant turn-on state, the control signal may be applied to a gate of the switch component to change the state of the HEMT to a turn-off state, and when the switch component 33 is in the constant turn-on state, no control signal is added to the gate of the switch component, or the control signal is 0). In this way, the gate G of the transistor 32 and the ground end GND are short-circuited via the switch component 33, and an electrostatic voltage V_{ESD} of the gate G of the transistor 32 is transmitted to the ground end GND through the switch component 33. After the integrated circuit is mounted to the package substrate, refer to FIG. 15. To ensure normal operation of the transistor 32, the gate G of the transistor 32 and the ground end GND need to be disconnected. Therefore, the switch component 33 is disconnected via the control signal, so that the gate G of the transistor 32 and the ground end GND are disconnected. It should be noted that before the integrated circuit is mounted to the package substrate, the test signal applied to the gate pad Pg and the control signal applied to the control pad Pm may be provided by a probe device that can provide a corresponding signal or voltage. Specifically, a corresponding probe may be connected to a corresponding pad on a fixture, and the foregoing signal or voltage may be applied.

In addition, in the process of mounting the integrated circuit to the package substrate, because the foregoing pads (the gate pad Pg, the source pad Ps, the drain pad Pd, and the control pad Pm) are packaged, in this process, the control signal cannot be applied to the control pad Pm via the probe. In addition, if the control signal may be applied to the control pad Pm via the probe, ESD may also be directly discharged via the probe, and there is no electrostatic discharge problem. Therefore, a switch component provided in another embodiment of this application may be a depletion mode HEMT. The depletion mode HEMT is in a constant turn-on state when no signal is applied to the gate (or the control signal is 0), and for the depletion mode HEMT, there is sufficient two-dimensional electron gas concentration when no voltage is applied to the gate. Therefore, a source S and a drain D of the depletion mode HEMT are in a constant turn-on state. To turn off the depletion mode HEMT, a negative voltage needs to be added to a gate G of the depletion mode HEMT. When the negative voltage provided by the gate G of the depletion mode HEMT is less than a threshold voltage, the depletion mode HEMT is turned off, and the negative voltage of the gate G of the depletion mode HEMT generates an electric field opposite to a built-in electric field, to reduce energy bending of a heterojunction interface of a barrier layer/channel layer, reduce a depth of a triangular potential well, and reduce the two-dimensional electron gas concentration. Therefore, in the process of mounting the integrated circuit to the package substrate, the electrostatic voltage V_{ESD} of the gate G of the transistor 32 may be transmitted to the ground end GND by using the depletion mode HEMT in the constant turn-on state.

Specifically, with reference to FIG. 16 to FIG. 18, a switch component 32 includes a depletion mode HEMT 33. A source S of the depletion mode HEMT 33 is coupled to a ground end GND, a drain D of the depletion mode HEMT 32 is coupled to the gate G of the transistor 32, and a gate G of the depletion mode HEMT 33 is coupled to the control pad Pm. The control pad Pm is electrically connected to the gate G of the depletion mode HEMT 33 through a via. The depletion mode HEMT 33 is in a turn-on state, or the gate G of the depletion mode HEMT 33 receives a first control voltage V1 (for example, the foregoing negative voltage) transmitted by the control pad Pm, and the depletion mode HEMT 33 is in a turn-off state under control of the first control voltage V1. In FIG. 16 to FIG. 18, the source S of the depletion mode HEMT may be understood as a first source, and the drain D of the depletion mode HEMT may be understood as a second source. In an embodiment, the source S of the depletion mode HEMT is coupled to a first end of an electrostatic discharge wire 33, and the drain D of the depletion mode HEMT is coupled to the gate of the transistor 32. In another embodiment, the drain D of the depletion mode HEMT may be coupled to a first end of an electrostatic discharge wire, and the source S of the depletion mode HEMT may be coupled to the gate of the transistor 32.

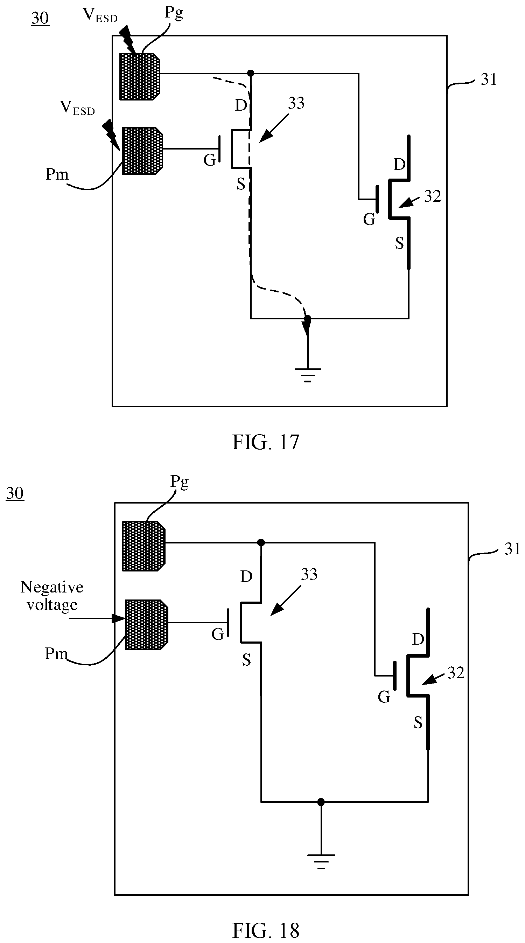

Specifically, in an on-chip screening stage before the integrated circuit is mounted to the package substrate, refer to FIG. 16. The negative voltage is applied to the control pad Pm, so that the depletion mode HEMT is in a turn-off state. In this way, the gate G and the ground end GND of the transistor 33 are disconnected, and a test signal may be applied to the gate pad Pg connected to the gate G of the transistor 32, and on-chip screening on the transistor 32 is implemented by detecting an output signal of the drain D of the transistor 32. In the process of mounting the integrated circuit to the package substrate, refer to FIG. 17. No voltage is applied to the control pad Pm (where the control pad Pm is suspended), so that the depletion mode HEMT is in the turn-on state. In this way, the gate G of the transistor 32 and the ground end GND are short-circuited via the depletion mode HEMT 33, and the electrostatic voltage V_{ESD} of the gate of the transistor 32 is transmitted to the ground end GND via the depletion mode HEMT 33 on the integrated circuit. After the integrated circuit is mounted to the package substrate, refer to FIG. 18. To ensure normal operation of the transistor 32, the gate G of the transistor 32 and the ground end GND needs to be disconnected. Therefore, the negative voltage is applied to the control pad Pm, so that the depletion mode HEMT is in the turn-off state, and the gate G of the transistor 32 and the ground end GND are disconnected.

In some examples, the channel layer and the barrier layer of the depletion mode HEMT include group III nitrides. The group III nitrides are a compound formed by two or more elements. Several elements of the group III nitrides include an element N, and include one or more of group III elements such as Al, Ga, and In in the element periodic table. Typical examples of the group III nitrides are, for example, GaN and AlGaN.

With reference to the foregoing descriptions, the depletion mode HEMT generally needs a negative voltage input by the gate to be turned off. In this embodiment of this application, a threshold voltage of the depletion mode HEMT is -60 V to -0.1 V When the HEMT operates in a terminal such as a mobile phone, a minimum power supply voltage that can be provided by the terminal such as the mobile phone is usually not too low, and is about -5 V to -10 V Therefore, in some applications, the threshold voltage of the depletion mode HEMT is greater than -10 V However, a threshold voltage of a depletion mode HEMT that uses group III nitrides is generally from -4 V to -2 V

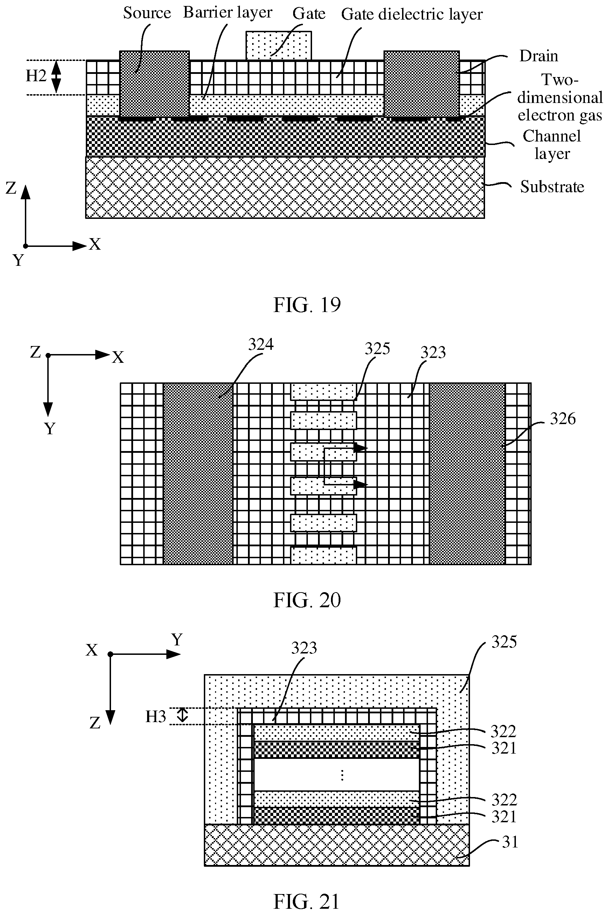

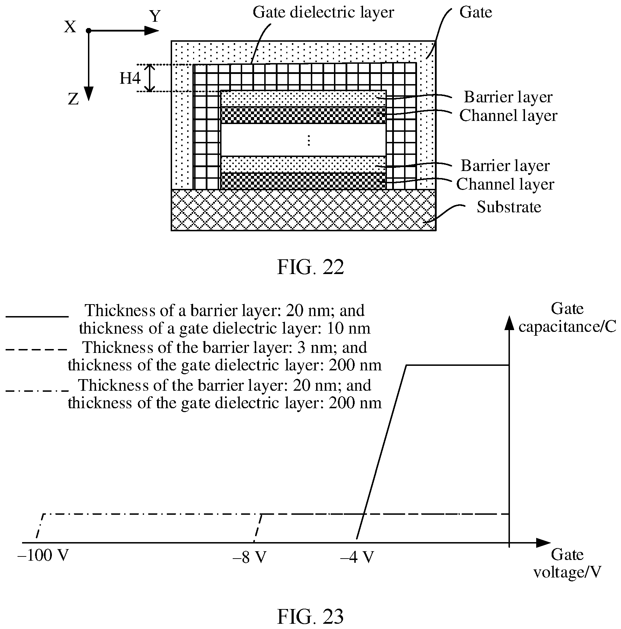

With reference to FIG. 15, in the process of mounting the integrated circuit to the package substrate, the control pad Pm also accumulates electrostatic charges. Therefore, the gate of the depletion mode HEMT also has an ESD problem. To reduce a risk of breakdown of a gate dielectric layer and the barrier layer of the depletion mode HEMT, a sufficient thickness of the gate dielectric layer of the depletion mode HEMT is set, and the thickness of the gate dielectric layer of the depletion mode HEMT is 0.1 nm to 200 nm. For example, to withstand 100 V ESD, the thickness of the gate dielectric layer is about 200 nm. When the gate dielectric layer of the depletion mode HEMT and the gate dielectric layer of the transistor use a same material, the thickness of the gate dielectric layer of the depletion mode HEMT is greater than the thickness of the gate dielectric layer of the transistor. In this case, the depletion mode HEMT provided in this embodiment of this application is also referred to as a depletion mode-thick-film HEMT (depletion mode-thick-film HEMT, DTF-HEMT). With reference to FIG. 8 and FIG. 19, FIG. 19 provides a schematic structural diagram of a depletion mode HEMT. Similar to a structure of the HEMT in FIG. 6, the depletion mode HEMT includes a channel layer, a barrier layer, a gate dielectric layer that are disposed on a substrate, and a pad on the gate dielectric layer, for example, a gate, a source, and a drain, where the source and the drain are in contact with the channel layer. A thickness H2 of the gate dielectric layer of the depletion mode HEMT is greater than a thickness H1 of the gate dielectric layer of the transistor 32 shown in FIG. 8. In addition, the depletion mode HEMT 33 and the transistor 32 may further include a fin-gate structure. With reference to FIG. 20 and FIG. 21, FIG. 20 shows a schematic structural diagram of a top view of a transistor in a fin-gate structure in a Z direction in a three-dimensional coordinate space XYZ, and FIG. 21 shows a schematic structural diagram of a cross section of a transistor in a fin-gate structure on an XZ plane. The gate 325 in the transistor 32 of the fin-gate structure surrounds the barrier layer 322 and the channel layer 321 that are disposed in a laminated manner, where a gate dielectric layer 323 is included between the gate 325 and each of the barrier layer 322 and the channel layer 321. With reference to FIG. 21 and FIG. 22 (where FIG. 22 shows a schematic structural diagram of a cross section of a depletion mode HEMT of a fin-gate structure on an XZ plane), in the depletion mode HEMT 33 of the fin-gate structure and the transistor 32, a thickness H4 of a gate dielectric layer of the depletion mode HEMT 33 is greater than a thickness H3 of a gate dielectric layer of the transistor 32.

In addition, in semiconductor devices, there are several physical trends: a. A thicker barrier layer indicates more electrons under a gate. b. A thicker gate dielectric layer indicates a smaller gate capacitance, c. A gate voltage corresponding to a moment at which the electrons under the gate are just depleted is referred to as a threshold voltage. In addition, an integral (or area) of a gate capacitor obtained within a gate voltage range corresponds to a total quantity of electrons. In this way, with reference to the foregoing descriptions about the threshold voltage and the thickness of the gate dielectric layer, it is expected that there are electrons under the channel layer (where in this way, it can be ensured that the depletion mode HEMT component presents a low-resistance state when the gate of the depletion mode HEMT component is suspended), and it is not expected that there are too many electrons under the channel layer (where if there are too many electrons, the threshold voltage is very low, and there is no negative voltage low enough to turn off the depletion mode HEMT component due to a limitation of a terminal application scenario such as a mobile phone). Therefore, in this embodiment of this application, how to make good use of a physical relationship of the integral of the gate capacitor within the gate voltage range is described. As shown in FIG. 23, after the gate dielectric layer is thickened (for example, from 10 nm to 200 nm), the gate capacitance is reduced, and a capability of depleting electrons becomes weak. Therefore, a lower negative voltage is required. As shown in FIG. 23, a voltage of -100 V is required to completely deplete electrons. This is obviously unacceptable. To reduce the voltage required for depleting electrons, another way is to reduce the total quantity of electrons, to reduce the integral area and consequently the voltage required for depleting electrons. However, in a group III nitride component, the most effective method for reducing a quantity of electrons is to reduce a thickness of the barrier layer. As shown in FIG. 23, the thickness of the barrier layer is reduced from 20 nm to 3 nm. In this case, under a -8 V voltage, the electrons can be completely depleted. This meets a capability of providing the voltage by the terminal. In this embodiment of this application, a thickness of the gate dielectric layer of the depletion mode HEMT is 0.1 nm to 100 nm. When the barrier layer of the depletion mode HEMT and the barrier layer of the transistor use a same material, a thickness of the barrier layer of the depletion mode HEMT is less than a thickness of the barrier layer of the transistor.

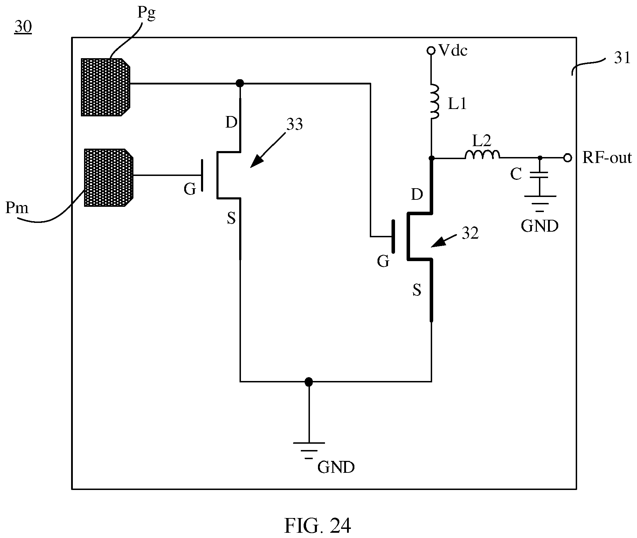

In addition, in another embodiment, with reference to FIG. 24, when the integrated circuit is used as a radio frequency circuit, another component may be further included, for example, an inductor L1 connected in series between a power supply Vdc and a transistor 32, and an inductor L2 connected in series between radio frequency output terminals RF-out, where the radio frequency output terminals RF-out and a ground end GND are further connected in series with a capacitor C. Certainly, FIG. 24 provides only one implementation of the radio frequency circuit. In another possible implementation, there may be more or fewer other components. In addition, it should be noted that these other components may be directly prepared on a substrate of an integrated circuit, or may be used as peripheral components to be connected to a pad on the integrated circuit to form a circuit with a specific function.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An integrated circuit, comprising: a substrate and a transistor disposed on the substrate, wherein a gate of the transistor is coupled to a first end of a switch component, and a second end of the switch component is coupled to a ground end; and
the switch component is configured to be in a turn-on state or a turn-off state under control of a control signal received by a control end, and the switch component in the turn-on state transmits an electrostatic voltage of the gate of the transistor to the ground end, or the switch component in the turn-off state disconnects the gate of the transistor from the ground end.

2. The integrated circuit according to claim 1, wherein the control end of the switch component is coupled to a control pad, and the control pad is configured to receive the control signal.

3. The integrated circuit according to claim 1, wherein the gate of the transistor is further coupled to a gate pad, and the gate of the transistor is electrically connected to the gate pad through a via.

4. The integrated circuit according to claim 1, wherein the switch component comprises a depletion mode HEMT, a first source of the depletion mode HEMT is coupled to the ground end, a second source of the depletion mode HEMT is coupled to the gate of the transistor, and a gate of the depletion mode HEMT is coupled to the control pad; and
the depletion mode HEMT is in a turn-on state, or the gate of the depletion mode HEMT receives a first control voltage transmitted by the control pad, and the depletion mode HEMT is in a turn-off state under control of the first control voltage.

5. The integrated circuit according to claim 1, wherein the transistor and/or the switch component comprises a transistor of a fin-gate structure.

6. The integrated circuit according to any one of claims 1 to 5, wherein a channel layer of the transistor comprises group III nitrides.

7. The integrated circuit according to any one of claims 1 to 5, wherein a channel layer of the transistor comprises a material different from a material of the substrate, and the channel layer is located on the substrate.

8. The integrated circuit according to claim 4, wherein a channel layer and a barrier layer of the depletion mode HEMT comprise group III nitrides.

9. The integrated circuit according to claim 8, wherein a thickness of a gate dielectric layer of the depletion mode HEMT is greater than a thickness of a gate dielectric layer of the transistor.

10. The integrated circuit according to claim 8, wherein a thickness of the barrier layer of the depletion mode HEMT is less than a thickness of a barrier layer of the transistor.

11. The integrated circuit according to claim 8, wherein a thickness of the barrier layer of the depletion mode HEMT is 0.1 nm to 100 nm.

12. The integrated circuit according to claim 8, wherein a thickness of a gate dielectric layer of the depletion mode HEMT is 0.1 nm to 200 nm.

13. The integrated circuit according to claim 4, wherein a threshold voltage of the depletion mode HEMT is -60 V to -0.1 V

14. The integrated circuit according to any one of claims 1 to 5, wherein the integrated circuit is a monolithic microwave integrated circuit MMIC.

15. A chip, comprising the integrated circuit according to any one of claims 1 to 14 and a package substrate, wherein the integrated circuit is coupled to the package substrate.

16. An electronic device, comprising a printed circuit board and the chip according to claim 15, wherein the chip is coupled to the printed circuit board.
